**Europäisches Patentamt**

**European Patent Office**

**Office européen des brevets**

(11) Veröffentlichungsnummer : **0 082 380**
**B1**

# EUROPÄISCHE PATENTSCHRIFT

(45) Veröffentlichungstag der Patentschrift :
21.11.85

(21) Anmeldenummer : 82111228.1

(22) Anmeldetag : 04.12.82

(51) Int. Cl.⁴: **H 03 G 3/20, H 03 G 7/00**

(54) **Elektronischer Verstärker mit einem durch eine Steuerspannung veränderbaren Übertragungsmass, insbesondere Expander.**

(30) Priorität : 21.12.81 DE 3150536

(43) Veröffentlichungstag der Anmeldung :
29.06.83 Patentblatt 83/26

(45) Bekanntmachung des Hinweises auf die Patenterteilung : 21.11.85 Patentblatt 85/47

(84) Benannte Vertragsstaaten :
AT BE CH DE FR GB IT LI NL SE

(56) Entgegenhaltungen :
DE-A- 2 924 373
US-A- 3 974 400

(73) Patentinhaber : Licentia Patent-Verwaltungs-GmbH
Theodor-Stern-Kai 1
D-6000 Frankfurt/Main 70 (DE)

(72) Erfinder : Schröder, Ernst, Dipl.-Ing.
Pinkenburger Strasse 25D
D-3000 Hannover 51 (DE)

## Beschreibung

Die Erfindung betrifft einen elektronischen Verstärker nach dem Oberbegriff des Anspruchs 1. Es ist bekannt, solche Verstärker ein- und ausschaltbar zu machen. Zu diesem Zweck kann der Verstärker in einer Betriebsstellung mit variabler Steuerspannung und in einer anderen Betriebsstellung mit fester Steuerspannung betrieben werden (vgl. dazu beispielsweise die DE-A-2 924 373).

Der Erfindung liegt die Aufgabe zugrunde, die Umschaltung zwischen den beiden Betriebsstellungen in einer Weise zu realisieren, die eine Zerstörung empfindlicher Bauteile, z. B. durch Überspannungen vermeidet. Diese Aufgabe wird gelöst durch die im Anspruch 1 gekennzeichneten Merkmale. Weiterbildungen der Erfindung sind in den Unteransprüchen gekennzeichnet.

Zur näheren Erläuterung der Erfindung werden im folgenden zwei Ausführungsbeispiele an Hand der Zeichnungen erläutert. Diese zeigen in

Figur 1 eine Prinzipdarstellung mit mechanischem Umschalter auf eine feste Steuerspannung,

Figur 2 eine Abwandlung der in Fig. 1 dargestellten Schaltung mit einem Transistorschalter,

Figur 3 eine erfindungsgemäße Weiterbildung der in Fig. 2 dargestellten Schaltung mit gekuppelter Herabsetzung der Steuerspannung und in

Figur 4 eine erfindungsgemäße Schaltung mit gekuppelter Herabsetzung der Eingangsspannung der Steuerschaltung.

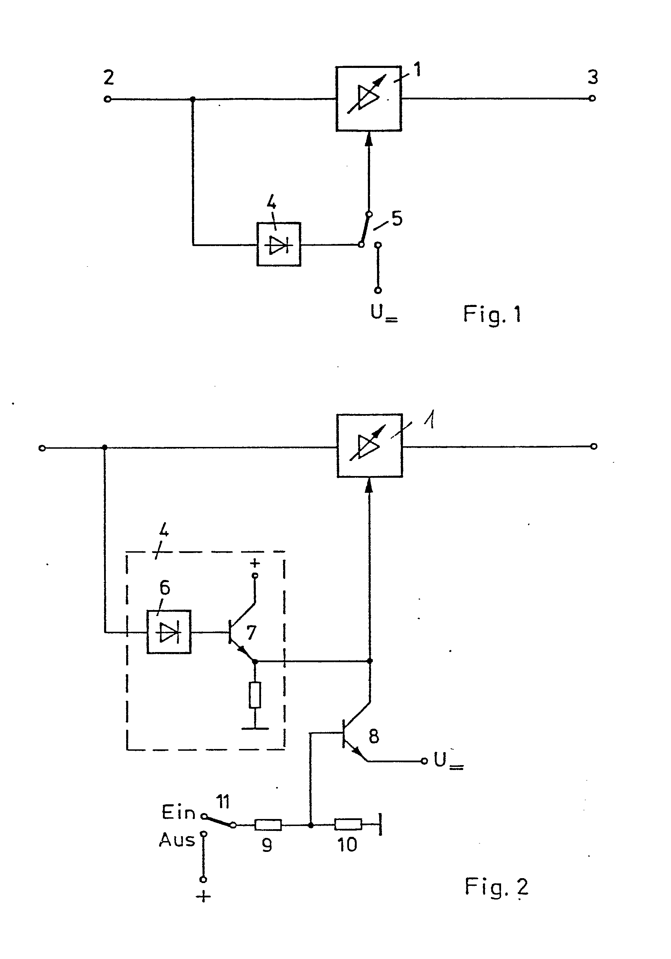

In Fig. 1 ist ein Verstärker 1 dargestellt, dem am Eingang 2 eine Signalspannung zugeführt wird und der an seinem Ausgang 3 eine verstärkte oder veränderte, z. B. expandierte Signalspannung abgibt. Der Verstärkungsgrad des Verstärkers 1 ist durch eine Steuerschaltung 4 veränderbar. Die Steuerschaltung 4 erzeugt die Steuerspannung für den Verstärker 1 in Abhängigkeit von den Signalspannungen, die vor oder hinter dem Verstärker 1 abgegriffen werden. Bei dem hier dargestellten Verstärker 1 werden die Signale vor dem Verstärker abgegriffen, weil sich hierdurch eine typische Expanderschaltung ergibt (siehe Proc. IEE, Vol. 111, No. 3, March 1964, S. 505 ff). Die Steuerspannung wird dem Verstärker 1 über einen Schalter 5 zugeführt, dessen andere Schalterstellung den Verstärker 1 mit einer Festspannungsquelle der Spannung $U_=$ verbindet. Der Variationsbereich der Steuerspannung sei angenommen mit 0,5 ... 10 V. Die Festspannung $U_=$ betrage 5 V. Das läßt sich zwar in klassischer Technik realisieren, ist aber für monolitisch integrierte Schaltungen ungeeignet, weil hierbei die Eigenschaften mechanischer Schalter (sehr hohe Sperr- und sehr kleine Durchgangswiderstände) nicht realisierbar sind.

Fig. 2 zeigt eine integrierbare Weiterbildung der Schaltung nach Fig. 1 mit einem Transistor 8, dessen Kollektor-Emitter-Strecke die Schalterstrecke des Schalters 5 vom Steuereingang des Verstärkers 1 zur Festspannung $U_=$ in Fig. 1 bildet. Die Basis des Transistors 8 ist über einen Basisspannungsteiler 9, 10 und einen Schalter 11 mit einer positiven Betriebsspannung verbunden. In der Stellung AUS des Schalters 11 ist die Kollektor-Emitter-Strecke des Transistors 8 niederohmig und der Steuereingang des Verstärkers 1 liegt im wesentlichen auf der Spannung $U_=$. Die Steuerschaltung 4 enthält neben dem eigentlichen Gleichrichter 6 als Ausgangsstufe einen als Emitterfolger geschalteten Transistor 7, dessen Ausgangselektrode ebenfalls mit dem Steuereingang des Verstärkers 1 verbunden ist. In Abhängigkeit vom Eingangssignal des Verstärkers 1 liefert der Gleichrichter 6 eine Steuerspannung zwischen 0,5 und 10 V, unabhängig von der Stellung des Schalters 11. Solange diese Spannung bei geschlossenem Schalter 11 und damit niederohmigem Transistor 8 niedriger als die Spannung am Transistor 8 zuzüglich der Flußspannung der Basis-Emitter-Strecke des Transistors 7 ist, so ist die Basis-Emitter-Strecke des Transistors 7 in Sperrichtung gepolt. Wächst diese Spannung aber darüber hinaus, so ist die Basis-Emitter-Strecke des Transistors 7 gefährdet. Wenn die Spannung $U_=$ am Transistor 8 wie in Fig. 1 etwa 5 V beträgt, so wäre die Basis-Emitter-Strecke des Transistors 7 durch alle Steuerspannungen gefährdet, die zwischen 5,6 V und 10 V liegen. (5,6 V = 5 V + mittlere Flußspannung einer Silizium-Diode).

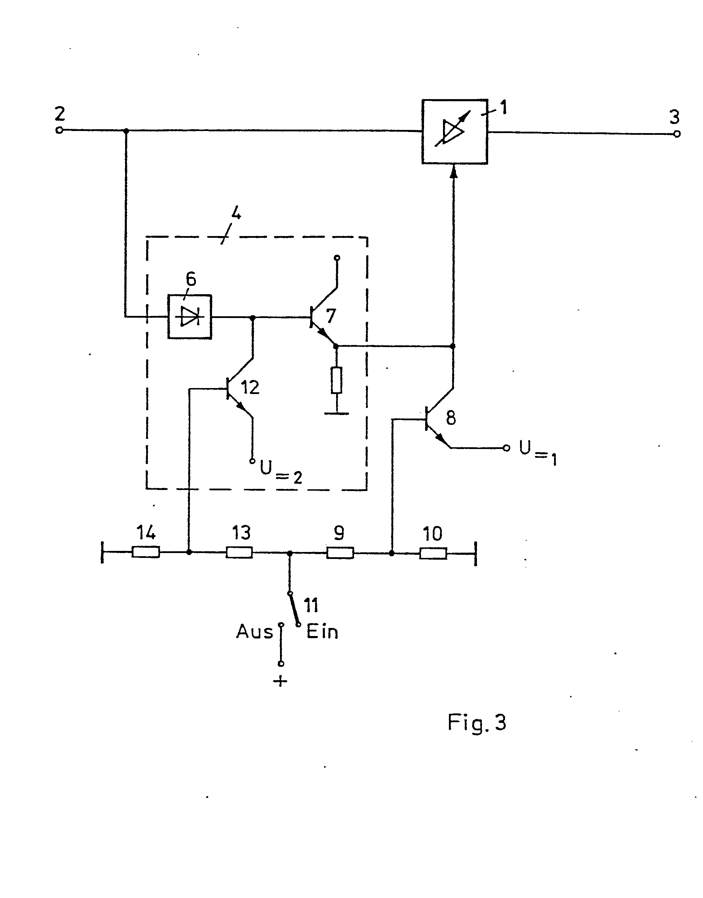

Die Fig. 2 entspricht im Prinzip der in DE-A 2 924 373 angegebenen Fig. 3. In der dort angegebenen Schaltung wird durch den Schalter 8 die in dem Gleichrichter 5 erzeugte Regelspannung in bestimmten Fällen, wie sie z. B. bei Kanalstörungen bei Schallplatten auftreten und in der Erkennungsschaltung 6 erkannt werden, auf einen festen Wert $U_{Ref}$ gezogen.

In Fig. 3 ist eine integrierbare Schaltung gemäß Fig. 2 dargestellt, bei der die durch die Umschaltung mögliche Gefährdung des Transistors 7 erfindungsgemäß vermieden ist. Zu diesem Zweck ist an den Ausgang des Gleichrichters 6 ein Transistor 12 so angeschlossen, daß seine Kollektor-Emitter-Strecke zwischen den Gleichrichter 6 und eine feste Gleichspannung $U_{=2}$ geschaltet ist und seine Basis über einen Basisspannungsteiler 13, 14 mit dem Schalter 11 verbunden ist, so daß der mit der festen Spannungsquelle $U_{=1}$ verbundene Transistor 8 und der mit der festen Spannungsquelle verbundene Transistor 12 zugleich umgeschaltet werden. Bei jeder Umschaltung des Schalters 11 auf die positive Betriebsspannung wird dadurch der Transistor 8 auf die feste Gleichspannung $U_{=1}$ geschaltet und die Steuerspannung auf die Festspannung $U_{=2}$. Wenn die Spannung $U_{=2}$ kleiner bemessen ist als $U_{=1}$, dann ist die Basis-Emitter-Strecke des Transistors 7 stets in Sperrichtung gepolt und nicht gefährdet. In Fig. 3 ist der Schalter 11 zugleich als Schalter für den Transistor 12 ausgenutzt. Es könnten aber auch zwei getrennte, gekuppelte Schalter verwendet werden.

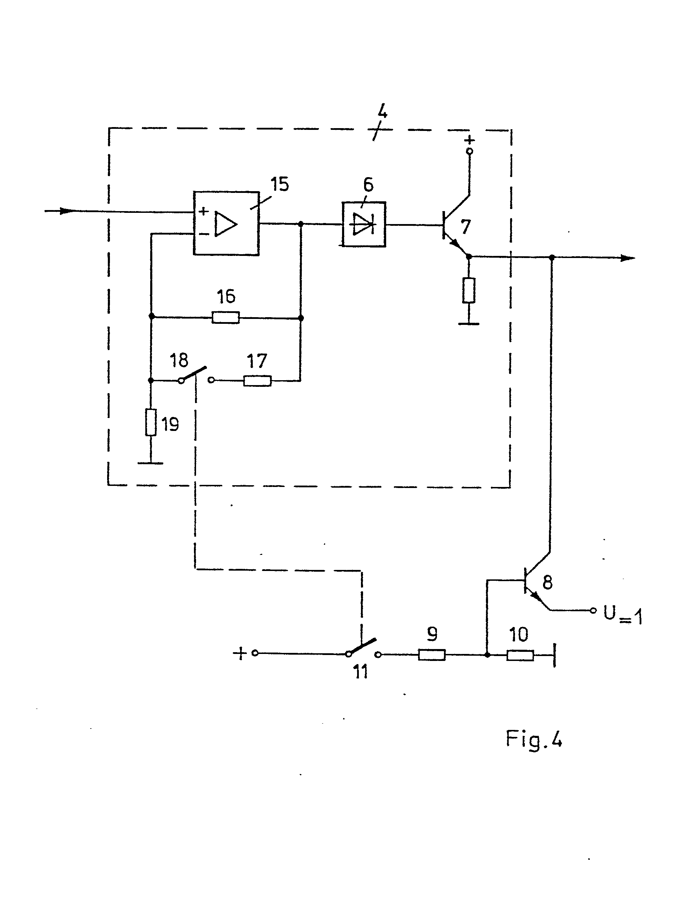

Fig. 4 zeigt eine andere erfindungsgemäße integrierbare Weiterbildung der Fig. 2, mit der die Nachteile der Fig. 2 vermieden werden können. Wie in Fig. 2 werden die Eingangssignale des Verstärkers 1 der Steuerschaltung 4 zugeführt. Vor den eigentlichen Gleichrichter 6 ist jedoch ein Operationsverstärker 15 geschaltet, dessen Ausgangselektrode mit der zweiten, über einen Widerstand 19 nach Masse geschalteten Eingangselektrode über einen Widerstand 16 verbunden ist. Parallel zum Widerstand 16 geschaltet ist die Serienschaltung eines Widerstandes 17 und eines Schalters 18. Wenn nur der Widerstand 16 dem Operationsverstärker zugeordnet ist, liefert der Gleichrichter 4 eine Steuerspannung, wie sie für den Betrieb des Verstärkers 1 als Expander erwünscht ist. Wenn durch den Schalter 18 der Widerstand 17 dem Widerstand 16 parallel geschaltet ist, ist der insgesamt wirksame Widerstand 16, 17 bekanntlich kleiner als der kleinste der beiden Widerstände. Die Widerstände werden zweckmäßig so bemessen, daß die Ausgangsspannung der Verstärkungs- (oder Dämpfungs-) schaltung 15, 16, 17, 19 um z. B. den Faktor 10 reduziert wird. Die mögliche Ausgangsspannung der Schaltung 6 wird damit ebenfalls reduziert. Damit wird auch hier eine Gefährdung des Transistors 7 vermieden. Die Schalter 11 und 18 sind gekuppelt oder kombiniert. In der Fig. 4 ist ein nichtinvertierender Verstärker 15, 16, 17, 19 dargestellt. Es ist auch möglich, hier einen invertierenden Verstärker einzusetzen und dessen Verstärkung über einen Schalter zu reduzieren.

Anstelle der Verstärkerschaltung 15, 16, 17, 19, die zwischen Übertragungsweg und Steuerschaltung 4, 6 eingefügt ist, ist es ebenfalls möglich, eine Dämpfungsschaltung vorzusehen, deren Dämpfungsgrad bei Betrieb des Verstärkers 1 heraufgesetzt wird.

## Patentansprüche

1. Elektronischer Verstärker (1) mit einen durch eine Steuerspannung veränderbaren Übertragungsmaß, insbesondere Expander, und einem Schalter für den wahlweisen Betrieb des Verstärkers (1) an fester Steuerspannung oder an veränderbarer Steuerspannung, dadurch gekennzeichnet, daß der Schalter (11) mit Mitteln (12, 18) gekuppelt ist, die bei Betrieb des Verstärkers (1) an fester Steuerspannung ($U_{=1}$) die Ausgangsspannung der die veränderbare Steuerspannung erzeugenden Steuerschaltung herabsetzen.

2. Verstärker nach Anspruch 1, dadurch gekennzeichnet, daß die Mittel (12, 18) mit einer zwischen dem Übertragungsweg und der Steuerschaltung (4, 6) eingefügte Verstärkerschaltung (15, 16, 17, 19) verbunden sind, deren Verstärkungsgrad bei Betrieb des Verstärkers (1) an fester Steuerspannung herabgesetzt wird.

3. Verstärker nach Anspruch 1, dadurch gekennzeichnet, daß die Mittel (12, 18) mit einer zwischen dem Übertragungsweg und der Steuerschaltung (4, 6) eingefügten Dämpfungsschaltung verbunden sind, deren Dämpfungsgrad bei Betrieb des Verstärkers (1) an fester Steuerspannung heraufgesetzt wird.

4. Verstärker nach einem der Ansprüche 1-3, dadurch gekennzeichnet, daß die Verstärkerschaltung (15, 16, 17, 19) einen Operationsverstärker (15) enthält, dessen einer Eingangsklemme das Signal zugeführt wird und dessen andere Eingangsklemme mit dem Spannungsbezugspunkt über einen Widerstand (19) und mit der Ausgangsklemme über die Parallelschaltung eines Widerstandes (16) und der Serienschaltung eines Widerstandes (17) und eines Schalters (18) verbunden ist, wobei der Schalter (18) mit dem Schalter (11) für die Umschaltung der Betriebsweise des Verstärkers (1) gekuppelt ist.

5. Verstärker nach einem der Ansprüche 1-3, dadurch gekennzeichnet, daß zwischen die Steuerschaltung (4, 6) und die Umschaltstelle (5, 8) zum Verstärker (1) die Kollektor-Emitter-Strecke eines Transistors (12) eingefügt ist, dessen Basis zusammen mit der Basis eines Schalttransistors (8) derart umgeschaltet wird, daß bei Betrieb an fester Steuerspannung der Ausgang der Steuerschaltung (4, 6) auf eine vorbestimmte, feste Gleichspannung ($U_{=2}$) geschaltet wird.

6. Verstärker nach Anspruch 5, dadurch gekennzeichnet, daß die vorbestimmte, feste Gleichspannung ($U_{=2}$) niedriger ist als die feste Steuerspannung ($U_{=1}$).

## Claims

1. Electronic amplifier (1) having a transmission factor which can be varied by a control voltage, especially an expander, and a switch for selectively operating the amplifier (1) with fixed control voltage or variable control voltage, characterized in that the switch (11) is coupled to means (12, 18) which, in the event of operation of the amplifier (1) with fixed control voltage ($U_{=1}$), reduce the output voltage of the control circuit providing the variable control voltage.

2. Amplifier according to Claim 1, characterized in that the means (12, 18) are coupled to an amplifying circuit (15, 16, 17, 19) inserted between the transmission path and the control circuit (4, 6), the degree of amplification of which is reduced in the event of operation of the amplifier (1) with fixed control voltage.

3. Amplifier according to Claim 1, characterized in that the means (12, 18) are coupled to a damping circuit inserted between the transmission path and the control circuit (4, 6), the degree of damping of which is reduced in the event of operation of the amplifier (1) with fixed control voltage.

4. Amplifier according to any one of the Claims 1-3, characterized in that the amplifying circuit (15, 16, 17, 19) comprises an operational amplifier to one input terminal of which the signal is applied, and the other input terminal of which is coupled to the reference voltage point by way of a resistance (19) and to the output terminal by way of the parallel combination of a resistance (16) and the series combination of a resistance (17) and a switch (18), the switch (18) being coupled to the switch (11), for the purpose of switching over the operational condition of the amplifier (1).

5. Amplifier according to any of the Claims 1-3, characterized in that the collector-emitter-path of a transistor (12) is inserted between the control circuit (4, 6) and the position (5, 8) at which switching over to the amplifier occurs, the base of which transistor is switched over together with the base of a switch transistor (8) in such a way that in the event of operation with fixed control voltage the output of the control circuit (4, 6) is switched to a predetermined fixed d. c. voltage $(U_{=2})$.

6. Amplifier according to Claim 5, characterized in that the predetermined fixed d. c. voltage $(U_{=2})$ is lower than the fixed control voltage $(U_{=1})$.

## Revendications

1. Amplificateur électronique (1) comportant un organe de transmission modifiable par une tension de commande, notamment un expanseur, et un commutateur pour alimenter sélectivement l'amplificateur (1) avec une tension de commande fixe ou une tension de commande variable, caractérisé en ce que le commutateur (11) est relié à des moyens (12, 18) qui, lors du fonctionnement de l'amplificateur (1) avec la tension de commande fixe $(U_{=1})$ réduisent la tension de sortie du circuit de commande produisant la tension de commande variable.

2. Amplificateur selon la revendication 1, caractérisé en ce que les moyens (12, 18) sont reliés à un circuit amplificateur (15, 16, 17, 19) interposé entre la voie de transmission et le circuit de commande (4, 6) et dont le degré d'amplification est réduit lors du fonctionnement de l'amplificateur (1) avec une tension de commande fixe.

3. Amplificateur selon la revendication 1, caractérisé en ce que les moyens (12, 18) sont reliés à un circuit d'amortissement interposé entre la voie de transmission et le circuit de commande (4, 6) et dont le degré d'amortissement est augmenté lors du fonctionnement de l'amplificateur (1) avec la tension de commande fixe.

4. Amplificateur selon une des revendications 1 à 3, caractérisé en ce que le circuit amplificateur (15, 16, 17, 19) contient un amplificateur opérationnel (15) dont une borne d'entrée reçoit le signal et dont l'autre borne d'entrée est reliée au point de tension de référence par l'intermédiaire d'une résistance (19) et à la borne de sortie par l'intermédiaire d'un circuit parallèle formé d'une résistance (16) et d'un circuit série comportant une résistance (17) et un interrupteur (18), l'interrupteur (18) étant relié au commutateur (11) d'inversion du mode de fonctionnement de l'amplificateur (1).

5. Amplificateur selon une des revendications 1 à 3, caractérisé en ce qu'entre le circuit de commande (4, 6) et le circuit de commutation (5, 8) de l'amplificateur (1) est interposée la voie émetteur-collecteur d'un transistor (12) dont la base est commutée en même temps que la base d'un transistor de commutation (8) de telle sorte que, lors du fonctionnement avec une tension de commande fixe, la sortie du circuit de commande (4, 6) est commutée à une tension continue fixe prédéterminée $(U_{=2})$.

6. Amplificateur selon la revendication 5, caractérisé en ce que la tension continue fixe prédéterminée $(U_{=2})$ est plus faible que la tension de commande fixe $(U_{=1})$.

Fig. 1

Fig. 2

Fig. 3

2

Fig.4